Europäisches Patentamt

European Patent Office

Office européen des brevets

(19)

(11) Veröffentlichungsnummer : **0 102 964**
**B1**

(12) **EUROPÄISCHE PATENTSCHRIFT**

(45) Veröffentlichungstag der Patentschrift :
**28.05.86**

(21) Anmeldenummer : **83900553.5**

(22) Anmeldetag : **05.02.83**

(86) Internationale Anmeldenummer :
**PCT/DE 83/00019**

(87) Internationale Veröffentlichungsnummer :
**WO/8303182 (15.09.83 Gazette 83/21)**

(51) Int. Cl.⁴ : **H 05 K    3/40**

(54) **VERFAHREN ZUR HERSTELLUNG ELEKTRISCHER VERBINDUNGEN ZWISCHEN DEN BEIDEN OBERFLÄCHEN EINER LEITERPLATTE UND DRUCKSTEMPEL ZUR DURCHFÜHRUNG DES VERFAHRENS.**

(30) Priorität : **03.03.82 DE 3207585**

(43) Veröffentlichungstag der Anmeldung :
**21.03.84 Patentblatt 84/12**

(45) Bekanntmachung des Hinweises auf die Patenterteilung : **28.05.86 Patentblatt 86/22**

(84) Benannte Vertragsstaaten :
**DE FR GB**

(56) Entgegenhaltungen :
**WO-A-83 /018 86
DE-A- 1 490 473
FR-A- 1 566 978**

(73) Patentinhaber : **ROBERT BOSCH GMBH
Postfach 50
D-7000 Stuttgart 1 (DE)**

(72) Erfinder : **STEIN, Helmut
Lehmkamp 35
D-3201 Diekholzen 2 (DE)**

EP 0 102 964 B1

## Beschreibung

### Stand der Technik

Die Erfindung geht aus von einem Verfahren zur Herstellung elektrischer Verbindungen zwischen den beiden Oberflächen einer Leiterplatte nach der Gattung des Anspruches 1. Ein derartiges Verfahren ist Gegenstand der PCT Anmeldung WO 83/01886, welche nach Artikel 54(3)(4) EPÜ als ältere europäische Anmeldung zu berüchsichtigen ist.

Die genannte Patentanmeldung betrifft ein Verfahren, bei dem die Kontaktierung der Leiterplattenoberflächen durch eine oder mehrere Bohrungen hindurch erfolgt, wobei eine leitfähige Paste mittels eines verformbaren Druckstempels aufgedruckt wird. Bei einem derartigen Verfahren ist es notwendig, gezielt Bohrungen in der Leiterplatte anzubringen, die dann mittels des Druckstempels mit der leitfähigen Paste beschichtet werden. Das Anbringen der Bohrungen in der Leiterplatte erfordert einen zusätzlichen Arbeitsaufwand, selbst wenn das anschließende Durchkontaktieren der Bohrungen in besonders einfacher und vorteilhafter Weise erfolgt.

Bekannte Verfahren zum elektrischen Kontaktieren der beiden Oberflächen von Leiterplatten verwenden entweder Bohrungen, welche von einem elektrisch leitfähigen Teil durchsetzt oder mit einer elektrisch leitfähigen Metallisierung versehen sind, oder es werden in noch aufwendigeren Verfahren elektrische Verbindungsbügel auf die Oberflächen aufgelötet. Diese bekannten Verfahren bedingen einen erheblichen fertigungstechnischen Aufwand und sind daher nicht kostengünstig realisierbar.

### Vorteile der Erfindung

Das erfindungsgemäße Verfahren mit den kennzeichnenden Merkmalen des Anspruches 1 gestattet es in besonders einfacher und zweckmäßiger Weise, die beiden Oberflächen einer Leiterplatte, bzw. gezielte Bereiche oder einzelne Leiterbahnen auf den verschiedenen Oberflächen der Leiterplatte miteinander zu verbinden, ohne daß aufwendige Bearbeitungen der Leiterplatte erforderlich sind. Das erfindungsgemäße Verfahren ermöglicht eine exakte Positionierung der elektrischen Verbindungen mit minimalem Materialaufwand gegenüber bekannten Verfahren, so daß zusätzlich zu den fertigungstechnischen Einsparungen und Verbesserungen auch noch durch Materialkostensenkung Vorteile entstehen.

Durch die in den abhängigen Ansprüchen 2-4 aufgeführten Maßnahmen sind zweckmäßige Weiterbildungen und Verbesserungen des im Anspruch 1 angegebenen Verfahrens möglich. Insbesondere das Aufdrucken einer Mehrzahl elektrisch leitfähiger Stege erlaubt eine besonders wirtschaftliche Verbindung verschiedener Bereiche oder Leiterbahnen auf den gegenüberliegenden Oberflächen der Leiterplatte. Auf diese Weise können ohne vorgeschaltete Arbeitsgänge auf besonders einfache Art eine Vielzahl verschiedener Verbindungen gleichzeitig hergestellt werden.

### Zeichnung

Die Erfindung ist in der Zeichnung schematisch dargestellt und in der nachfolgenden Beschreibung näher erläutert. Es zeigen Figur 1 eine Ansicht in Richtung des Pfeiles I in Figur 2, Figur 2 eine Draufsicht auf eine Leiterplatte und Figur 3 eine vereinfachte Darstellung des elastisch verformbaren Druckstempels.

### Beschreibung des Ausführungsbeispiels

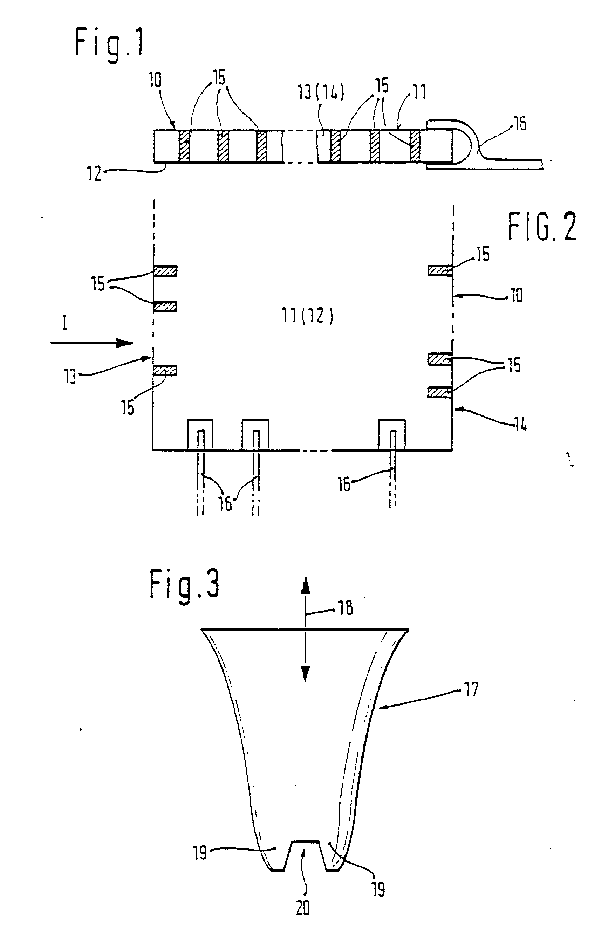

Figur 1 zeigt eine schematische Darstellung, gesehen in Richtung des Pfeiles I in Figur 2. Hierin ist mit 10 eine Leiterplatte bezeichnet, ihre Oberseite trägt die Bezugsziffer 11 und ihre Unterseite die Bezugsziffer 12. Auf den Stirnseiten 13 und 14 der Leiterplatte 10 sind elektrisch leitfähige Stege 15 angeordnet, welche die Oberseite 11 mit der Unterseite 12 verbinden. Zwischen den einzelnen Stegen 15 können nicht dargestellte Leiterbahnen, flächenhafte elektrisch leitfähige Schichten oder dgl. liegen. Mit 16 ist ein Anschlußteil eines Anschlußkammes bezeichnet, welches an einer nicht durch die Stege 15 belegten Stirnfläche der Leiterplatte 10 angreift.

Die in Figur 2 gezeichnete Draufsicht auf die Leiterplatte 10 zeigt, daß die Stege 15 die Oberseite 11 und, was aus der Zeichnung nicht ersichtlich ist, auch die Unterseite 12 der Leiterplatte 10 umgreifen, so daß die Stege leicht mit nicht dargestellten Leiterbahnen auf der Leiterplatte kontaktiert werden können. Die Anschlußteile 16 bilden eine kammartige Anschlußleiste, welche an einer nicht mit Stegen 15 belegten Stirnseite der Leiterplatte angreift.

In Figur 3 ist schematisch ein Druckstempel 17 gezeichnet, welcher sich beim Aufdrucken einer leitfähigen Paste im Bereich der Stege 15 in Richtung des Pfeiles 18 hin und her bewegt. An der Unterseite des Druckstempels 17 umschließen Lippen 19 eine trapezförmige Aussparung 20. Bei Ausübung eines Druckes auf den Stempel 17 in Richtung der Aussparung 20 wird der aus elastischem Material wie z. B. Silikongummi hergestellte Stempel verformt, so daß sich die Lippen 19 an eine in die Aussparung 20 eingreifende Leiterplatte anlegen und die Teile der Stege 15 drucken, welche die Oberseite 11 und die Unterseite 12 bedecken. Zur Aufnahme der elektrisch leitfähigen Druckpaste wird der Stempel mit der Aussparung 20 auf ein Klischee aufgedrückt, auf welches vorher die leitfähige Paste aufgebracht worden ist.

Durch das vorgeschlagene Verfahren ergibt sich eine besonders vorteilhafte und wirtschaftliche Möglichkeit zum Herstellen elektrischer Verbindungen zwischen der Oberseite 11 und der Unterseite 12 einer Leiterplatte 10, so daß beide Leiterplattenseiten schaltungstechnisch nutzbar sind ohne kostspielige Maßnahmen für die Herstellung der elektrischen Verbindungen zwischen den beiden Leiterplattenseiten. Die zum Drucken der Stege 15 verwendete leitfähige Paste ist im Handel erhältlich, als leitfähige Substanzen enthält sie vorzugsweise Gold, Silber, Palladium aber auch unedle Metalle wie Kupfer, Nickel oder Aluminium sowie Kohlenstoff. Ihre mechanische und elektrische Beständigkeit erhält die aufgedruckte Paste durch einen Brennvorgang, welcher bei keramischen Trägern vorzugsweise bei ca 850 °C erfolgt, bei Epoxidharz-Leiterplatten jedoch auch bei ca 200 °C durchgeführt werden kann. Neben den zuvor genannten Pasten sind weitere, geeignete Materialien als Dickschichtpasten Fachhandel erhältlich.

Mit dem erfindungsgemäßen Verfahren wird es ohne aufwendige Vorarbeiten an der Leiterplatte möglich, in einem Arbeitsgang die beiden Oberflächen einer Leiterplatte 10 durch eine den Rand der Leiterplatte umgreifende Druck-Beschichtung miteinander zu verbinden. Hierbei können gleichzeitig beispielsweise auch zwei gegenüberliegende Stirnseiten 13, 14 der Leiterplatte 10 in einem Druckvorgang mit den Stegen 15 bedruckt werden. Mit dem Druckvorgang werden gleichzeitig die elektrischen Verbindungen mit nicht dargestellten Leiterbahnen hergestellt, wodurch das Verfahren weiter an Wirtschaftlichkeit gewinnt.

## Patentansprüche

1. Verfahren zur Herstellung elektrischer Verbindungen zwischen den Oberflächen einer Leiterplatte mittels einer elektrisch leitfähigen Beschichtung, welche durch einen elastisch verformbaren Druckstempel aufgebracht wird, dadurch gekennzeichnet, daß die elektrisch leitfähige Beschichtung den Rand der Leiterplatte (10) umgreifend aufgedruckt wird.

2. Verfahren nach Anspruch 1, dadurch gekennzeichnet, daß der Druckvorgang in einem Arbeitsgang gleichzeitig von mehreren, vorzugsweise von zwei gegenüberliegenden Stirnseiten der Leiterplatte (10) aus erfolgt.

3. Verfahren nach Anspruch 1 oder 2, dadurch gekennzeichnet, daß die elektrisch leitfähige Beschichtung in Form einer Mehrzahl schmaler Stege (15) aufgebracht wird.

4. Verfahren nach Anspruch 3, dadurch gekennzeichnet, daß durch die Stege (15) verschiedene Leiterbahnen auf den Oberflächen (11, 12) der Leiterplatte (10) miteinander verbunden werden.

5. Druckstempel zur Durchführung des Verfahrens nach einem der vorhergehenden Ansprüche, dadurch gekennzeichnet, daß der Stempel (17) an seinem Vorderteil U-förmig bis trapezförmig ausgespart ist und lippenförmige Vorsprünge (19) zeigt, die durch Verformung des Stempels (17) von außen an die Leiterplattenoberflächen (11, 12) angedrückt werden.

## Claims

1. Process for the production of electrical connections between the surfaces of a printed circuit board by means of an electrically conductive coating which is applied by an elastically deformable pressure stamp, characterised in that the electrically conductive coating is imprinted on the edge of the printed circuit board (10) reaching around it.

2. Process according to Claim 1, characterised in that the printing process is performed in one operation simultaneously from several, preferably from two opposite, faces of the printed circuit board (10).

3. Process according to Claim 1 or 2, characterised in that the electrically conductive coating is applied in the form of a plurality of narrow lugs (15).

4. Process according to Claim 3, characterised in that various conductor tracks on the surfaces (11, 12) of the printed circuit board (10) are connected to one another by the lugs (15).

5. Pressure stamp for the implementation of the process according to one of the preceding claims, characterised in that the stamp (17) is recessed at its front portion in U-shaped to trapezoidal form and displays lipshaped projections (19) which are pressed by deformation of the stamp (17) from outside against the printed circuit board surfaces (11, 12).

## Revendications

1. Procédé pour la réalisation de connexions électriques entre les deux faces d'une carte de circuit imprimé au moyen d'un revêtement électriquement conducteur appliqué au moyen d'un tampon élastiquement déformable, caractérisé en ce que le revêtement électriquement conducteur est appliqué en enserrant le bord de la carte (10).

2. Procédé selon la revendication 1, caractérisé en ce que le processus d'impression se fait en une étape de travail simultanément à partir de plusieurs, de préférence de deux faces frontales opposées de la carte (10).

3. Procédé selon la revendication 1 ou la revendication 2, caractérisé en ce que le revêtement électriquement conducteur est appliqué sous forme d'un grand nombre de barrettes étroites (15).

4. Procédé selon la revendication 3, caractérisé en ce que différents circuits conducteurs situés sur les faces (11, 12) de la carte (10) sont réunis l'un à l'autre au moyen des barrettes (15).

5. Tampon pour l'exécution du procédé selon l'une des revendications précédentes, caractérisé en ce que le tampon (17) présente sur sa partie avant un évidement en forme de U, allant jusqu'à une forme trapézoïdale et présente des saillies en forme de lèvres (19) qui sont pressées par la déformation du tampon (17), de l'extérieur, sur les faces (11, 12) de la carte de circuit imprimé.

# Fig.1

# FIG.2

# Fig.3

1